# EUROPÄISCHE PATENTANMELDUNG

(11) **EP 1 091 420 A2**
(43) Veröffentlichungstag der Anmeldung: **11.04.2001**
(21) Anmeldenummer: 00125466.3
(22) Anmeldetag: 27.04.1999
(51) Int. Cl.: H01L 31/0224, H01L 31/18, H01L 31/068

(54) **Verfahren zur Herstellung von Kontaktstrukturen in Solarzellen**

(30) Priorität: 29.04.1998 DE 19819200
(62) Teilanmeldung aus: 99929034.9
(71) Anmelder: FRAUNHOFER-GESELLSCHAFT ZUR FÖRDERUNG DER ANGEWANDTEN FORSCHUNG E.V., 80636 München (DE)
(72) Erfinder: Lüdemann, Ralf, 79100 Freiburg (DE); Schaefer, Sebastian, 79106 Freiburg (DE)
(74) Vertreter: Gagel, Roland, Dr.

(57) **Zusammenfassung**

Die Erfindung betrifft ein Verfahren zur Herstellung von Kontaktstrukturen in Halbleiterbauelementen, insbesondere Solarzellen, sowie Halbleiterbauelemente mit diesen Kontaktstrukturen.

Gemäß einem Aspekt der vorliegenden Erfindung werden nach dem Positionieren einer Ätzmaske (3) über einer ersten Schicht bzw. Schichtfolge (2) Vertiefungen durch die erste Schicht bis an oder in eine darunterliegende zweite Schicht (1) geätzt, wobei das Positionieren der Ätzmaske (3) durch Auflegen oder Aufklemmen über der ersten Schicht oder Schichtfolge (2) erfolgt. Das Ätzen erfolgt so, daß die Ätzmaske (3) unterätzt wird. Anschließend wird elektrisch leitfähiges Material (9) in die Vertiefungen eingebracht, wobei die Ätzmaske (3) eine Schattenmaske für das Einbringen des Materials bildet, und die Ätzmaske (3) entfernt. Das leitfähige Material wird nur bis zu einer Höhe in die Vertiefungen eingebracht, bei der noch kein Kontakt zwischen dem leitfähigen Material (9) und der ersten Schicht (2) besteht.

Die Strukturen erlauben erstmals die Kontaktierung der Basis durch den Emitter ohne zusätzliche Maskierung. Die Erfindung ermöglicht dadurch eine einfachere und kostengünstige Herstellung von Metallkontakten an Solarzellen.

## Beschreibung

Die Erfindung betrifft ein Verfahren zur Herstellung von Kontaktstrukturen in Solarzellen. Die Erfindung bezieht sich insbesondere auf Strukturen von Gräben oder Löchern und Verfahren zu ihrer Realisierung, die neuartige Kontaktierungen von Solarzellen ermöglichen.

Solarzellen sind Bauelemente, die Licht in elektrische Energie umwandeln. Üblicherweise bestehen sie aus einem Halbleitermaterial, das Bereiche bzw. Schichten unterschiedlicher Beweglichkeit für positive und negative Ladungsträger, n- bzw. p-leitende Bereiche, enthält. Die Bereiche werden als Emitter bzw. Basis bezeichnet. Durch einfallendes Licht erzeugte positive und negative Ladungsträger werden getrennt und können durch auf den jeweiligen Bereichen vorgesehene metallische Kontakte abgeführt werden. Zur nutzbaren elektrischen Leistung der Solarzellen tragen entsprechend nur solche Ladungsträger bei, die die Kontakte erreichen und nicht vorher mit einem jeweils anderen Ladungsträger rekombinieren.

Die metallischen Kontakte werden in der Regel durch Aufdampfen von Metall, das anschließend galvanisch verdickt wird, durch stromlose Abscheidung von Nickel oder durch Aufdrucken einer Metallpaste auf die Oberfläche der zu kontaktierenden Bereiche hergestellt. Wenn sich diese Bereiche nicht über die gesamte Solarzellenoberfläche erstrecken oder aus anderen Gründen (z.B. Abschattung des Lichts, erhöhte Rekombination am Kontakt, etc.) das Metall nur stellenweise aufgebracht werden darf, wie weiter unten beschrieben, wird dies durch Verwendung von Masken bei der Herstellung sichergestellt.

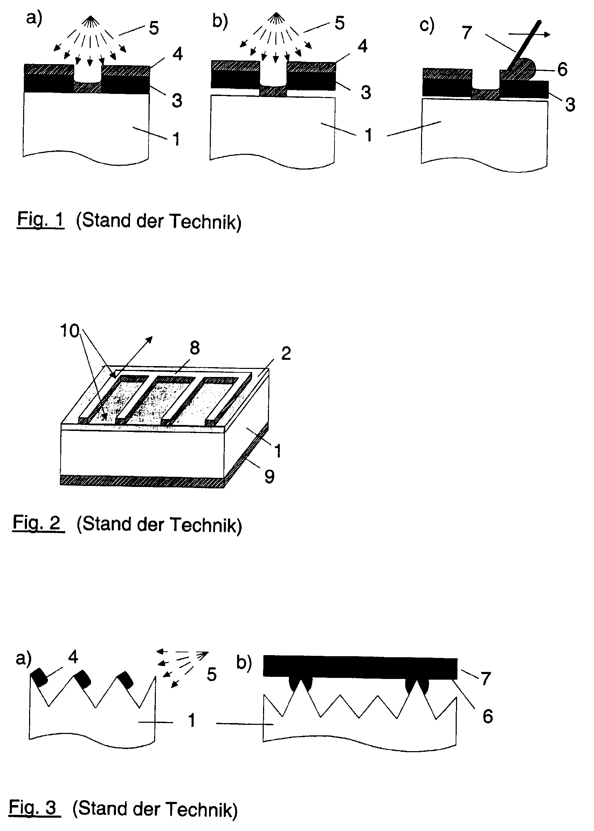

Beim Aufdampfen von Metall wird üblicherweise eine photolithographisch hergestellte Lackmaske (3) direkt auf die Oberfläche der zu kontaktierenden Schicht (1) aufgetragen, wie dies in Figur 1a dargestellt ist. Danach wird eine Metallschicht (4) aus dem Metalldampf (5) ganzflächig auf der Oberfläche abgeschieden und die Lackmaske entfernt.

Eine andere Möglichkeit der Strukturierung besteht im Auflegen bzw. Aufklemmen einer Schattenmaske (3), wie in Figur 1b gezeigt. Die weiteren Prozeßschritte erfolgen wie in Verbindung mit Figur 1a beschrieben. Zum Aufbringen der Metallisierung sind auch Druckverfahren anwendbar. Auch hierbei werden Masken, beispielsweise Siebdruckmasken (3) oder vorgeformte Klischees (Stempel- oder Tampondruck), eingesetzt. Figur 1c zeigt das Siebdruckverfahren, bei dem Metall in Form einer Metallpaste (6) mittels eines Rakels (7) in die Zwischenräume der Maske gedrückt wird.

Die mit den gerade beschriebenen Verfahren hergestellten Metallkontakte werden meist in einer kammartigen Form realisiert, d.h. sie bilden sog. Grids.

In der einfachsten Form bestehen Solarzellen aus ganzflächigen Basis- und Emitterbereichen, wobei der Emitter meist auf der dem Licht zugewandten Seite (Vorderseite) liegt (siehe Figur 2). Dadurch kann die Basis durch ganzflächiges Aufbringen von Metall auf der Rückseite kontaktiert werden. Der Emitter wird mit einem Grid kontaktiert, mit dem Ziel, möglichst wenig Licht durch Reflexion am Metallkontakt für die Solarzelle zu verlieren. Man spricht von der Abschattung der Solarzelle durch die Kontaktierung. Je geringer die Abschattung, d.h. je mehr Licht in die Solarzelle gelangen kann, desto größer ist die Stromausbeute der Zelle pro Fläche, und somit der Wirkungsgrad. Um einen Stromtransport mit geringem Widerstand zu garantieren, dürfen der Abstand der Gridfinger nicht zu groß, Anzahl und Querschnitt nicht zu klein gewählt werden. Eine gewisse Abschattung muß also in Kauf genommen werden.

Figur 2 zeigt eine Solarzelle mit der Basisschicht (1), der Emitterschicht (2) und dem Emittergrid (8) zur Kontaktierung des Emitters. Die Vorderseite, von der das Licht (10) einfällt, wird durch die Emitterschicht (2) gebildet. Auf der Rückseite der Basisschicht (1) ist der Basiskontakt (9) ganzflächig aufgebracht.

Die WO 88/03709 A1 beschreibt eine derartige Solarzelle. Bei dieser Solarzelle wird die Emitterschicht über Gräben kontaktiert, die wiederum mit einem auf der Oberfläche der Solarzelle aufgebrachten Grid in Kontakt sind. Die Gräben werden bei dieser Solarzelle über einen Ätzprozeß erzeugt. Durch die Anordnung und Form der Grids muß jedoch auch hier eine unerwünschte Abschattung der Oberfläche der Solarzelle in Kauf genommen werden.

Eine Möglichkeit, die Abschattung durch die Metallkontakte zu verringern, besteht darin, die Gridfinger hoch und schmal zu gestalten, wie dies in S.W. Glunz et al., Optimized High-Efficiency Silicon Solar Cells with J_{SC}= 42 mA/cm² and η= 23.3 %, 14^{th} EUPVSEC Barcelona, Spain (1997), S. 392-395, vorgeschlagen wird. Dadurch wird die von den Kontakten abgedeckte Solarzellenfläche verringert, ohne den Querschnitt und damit die Leitfähigkeit des Grids zu verringern.

Das Verfahren erfordert jedoch eine spezielle Lackmaske, die sicherstellt, daß während der galvanischen Verdickung des aufgedampften Metalls das Grid nur in die Höhe wächst. Das Aufdrucken solcher feiner Kontakte ist nach dem heutigen Stand der Technik nicht möglich.

In der US 4726850 wird ein anderes Konzept, die sog. "buried contact cell", vorgestellt. Diese basiert auf durch Laser erzeugten Gräben (siehe auch US 4626613), die mit Metall gefüllt werden. Die Abschattung der Solarzelle wird dabei durch die Breite der Gräben bestimmt und kann minimiert werden, während durch die Tiefe der Gräben der Querschnitt der Kontakte erhalten bleibt. Ein weiterer Vorteil von solchen vergrabenen Kontakten liegt in der größeren Kontaktfläche zwischen Metall und Solarzelle, wodurch der Kontaktwiderstand herabgesetzt wird.

Ein Nachteil dieses Verfahrens besteht jedoch darin, daß das Erzeugen der Gräben mittels Laser ein sehr aufwendiger Prozeß ist. Hierbei muß der Laserstrahl über eine präzise Ablenk- oder Verfahreinrichtung über die gesamte Oberfläche der Solarzelle geführt werden. Durch die Einwirkung des Laserstrahls wird zudem die Solarzelle geschädigt, so daß die Gräben anschließend geätzt werden müssen, um die geschädigte Schicht abzutragen. Dies gilt auch für mechanisch erzeugte, beispielsweise gesägte, Gräben.

In der Veröffentlichung von C.M. Chong. et al., Plasma-grooved, buried contact silicon solar cells, Journal of Appl. Phys. 69(1991), No. 7, Seiten 4135 - 4136, werden ebenfalls Solarzellen mit vergrabenen Kontakten in der Emitterschicht beschrieben, die gegenüber anderen Solarzellen eine geringere Abschattung der Oberfläche durch die Kontaktierung aufweisen. Die Basis wird von der Rückseite der Solarzelle über eine ganzflächig aufgebrachte Metallisierung kontaktiert. Das Einbringen der Gräben erfolgt hierbei durch reaktives Sputterätzen.

Neben der Steigerung des Wirkungsgrades stellen die Vereinfachung der Herstellung und die Entwicklung billigerer Ausgangsmaterialien die wichtigsten Herausforderungen für die Solarzellentechnologie dar. Bezogen auf die Kontaktierung bedeutet der Verzicht auf Masken bei der Metallisierung eine erhebliche Vereinfachung. Zwei kürzlich beschriebene Verfahren zur maskenlosen Herstellung von Grids basieren auf der Texturierung der Oberfläche durch gesägte Gräben ähnlich einem Sägezahnmuster.

So wird in M. Verbeek et al., Mechanically Grooved High-Efficiency Silicon Solar Cells with Self-Aligned Metallisation, 25^{th} IEEE-PVSC Washington, U.S.A. (1996), S. 1-4, ein erstes Verfahren vorgeschlagen, bei dem durch schräges Bedampfen aufgrund der gegenseitigen Abschattung nur die Spitzen der "Sägezähne" metallisiert werden. Dies ist schematisch in Figur 3a dargestellt. Die Figur zeigt die gesägte Oberfläche einer zu kontaktierenden Schicht (1), an deren Spitzen durch schräges Bedampfen (5) nur einseitig eine Metallisierung (4) erzeugt wird.

Ein zweites Verfahren wird von C. Gerhards et al., Mechanically V-Textured Low Cost Multicrystalline Silicon Solar Cells with a Novel Printing Metallization, 26^{th} IEEE-PVSC Anaheim, U.S.A. (1997), S. 43-46, beschrieben. Das Verfahren ermöglicht durch die Erzeugung unterschiedlich hoher "Sägezähne" eine selektive Metallisierung durch sog. "roller printing", bei dem eine Metallpaste (6) mittels eines Rakels (7) aufgetragen wird, wie in Figur 3b dargestellt.

Bei beiden Verfahren muß jedoch nach dem Sägen eine ca. 3-5 µm dicke geschädigte Schicht durch Ätzen entfernt werden. Außerdem eignen sie sich aufgrund der beim Sägen auftretenden mechanischen Verspannungen nicht für empfindliche Materialien, wie z.B. einige bandgezogene Materialen oder dünne abgeschiedene Schichten. Auch für Dünnschichtsolarzellen sind sie ungeeignet, da die minimal erzielbaren Sägetiefen meist größer als die Dicke der aktiven Solarzellenschichten (3-50 µm) sind.

Im Zuge der Entwicklung von billigeren Ausgangsmaterialien kommt dem Konzept der Dünnschichtsolarzelle auf einem kostengünstigen Substrat eine besondere Bedeutung zu. Die Solarzelle besteht dabei nur aus einer dünnen Halbleiterschicht (3-50 µm), die auf ein Trägermaterial aufgebracht ist. Viele dieser Substrate sind allerdings nicht leitfähig. Deshalb kann der Kontakt zur Basis nicht von der Rückseite über das Substrat erfolgen. Statt dessen muß ein sog. Einseitengrid verwendet werden, das aus zwei ineinandergreifenden Grids, jeweils zur Kontaktierung der Basis und des Emitters, besteht.

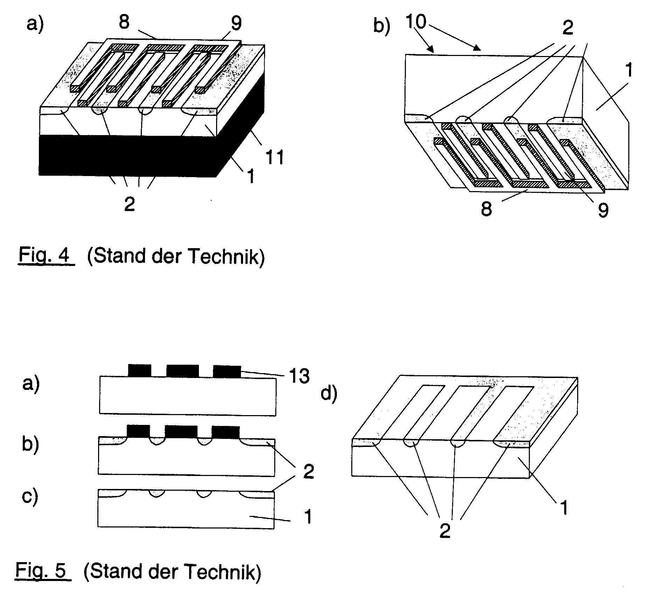

Figur 4a zeigt ein Beispiel für den Aufbau einer Dünnschichtsolarzelle mit Einseitenkontaktierung. Die Basisschicht (1) ist hier auf einem isolierenden Substrat (11) aufgebracht. In die Basisschicht sind die selektiven Emitterbereiche bzw. -schichten (2) eingebettet. Die Kontaktierung sowohl der Emitterbereiche als auch der Basis erfolgt durch ineinandergreifende Emitter- (8) bzw. Basisgrids (9), wie in der Figur dargestellt.

Das Konzept der Einseitenkontaktierung kann gleichzeitig dazu genutzt werden, auf einem Substrat mehrere Solarzellen miteinander zu verschalten, wie in der deutschen Patentanmeldung P 197 15 138.8 beschrieben ist.

Die gleichen Ausführungen gelten auch für die Rückseitenkontaktzelle, einem Konzept für hocheffiziente Solarzellen, wie sie in Figur 4b gezeigt ist. Hier sind beide Kontakte sowie die selektiven Emitterbereiche (2) auf der Rückseite der Basisschicht (1) ausgeführt, um die Abschattung von Licht (10) auf der Vorderseite völlig zu eliminieren. Werden die Kontakte als schmale Grids (8, 9) realisiert, kann auch Licht, das von der Rückseite auf die Solarzelle gelangt, zur Stromerzeugung beitragen (sog. "bifacial cell").

Die Realisierung dieser Einseitenkontaktierung ist bislang allerdings nur durch sehr aufwendige Verfahren möglich. Dabei wird über mehrere Maskenschritte ein sog. selektiver Emitter erzeugt, d.h. der Emitter besteht nicht aus einer homogenen Schicht, sondern aus Teilbereichen, die der Form des Emittergrids entsprechen. Das Herstellungsverfahren ist in Figur 5 dargestellt. Die Oberfläche der Basisschicht (1) wird zunächst maskiert (Figur 5a). Anschließend wird das Material zur Erzeugung der Emitterbereiche (2) an den durch die Maske (3) vorgegebenen Stellen in die Oberfläche der Basisschicht (1) eindiffundiert (Figur 5b). In einem anschließenden "lift-off"-Prozeß wird die Maske (3) entfernt (Figur 5c), so daß die in Figur 5d gezeigte Struktur mit Basis (1) und selektiven Emitterbereichen (2) resultiert. Auf diese Weise bleiben an der Oberfläche Bereiche, die zur Basis (1) gehören, erhalten und können an der Oberfläche kontaktiert werden.

Das genaue Aufbringen der jeweiligen Metallkontakte auf den entsprechenden Emitter- bzw. Basisbereich stellt jedoch ein kritisches Justageproblem dar und erfordert zusätzliche Masken.

Die DE 3919693 beschreibt eine Solarzelle mit überhängender dielektrischer Schicht sowie ein Verfahren zu deren Herstellung. Bei dem Herstellungsverfahren wird eine dielektrische Schicht auf die Oberfläche der Emitterschicht der Solarzelle aufgebracht und strukturiert. Anschließend wird diese dielektrische Schicht als Ätzmaske verwendet, um Gräben oder Vertiefungen durch die Emitterschicht hindurch in die darunterliegende Basis der Solarzelle zu ätzen. Dieser Ätzvorgang wird derart durchgeführt, dass die dielektrische Ätzmaske dabei unterätzt wird. Anschließend wird Metall in die entstandene Vertiefung eingebracht, wobei die überstehenden Bereiche der dielektrischen Schicht als Schattenmaske dienen. Das Metall wird nur bis zu einer Höhe in die Vertiefungen eingebracht, bei der noch kein Kontakt zur Emitterschicht hergestellt ist. Auf diese Weise läßt sich eine Kontaktierung der Basisschicht einer Solarzelle durch die Emitterschicht hindurch realisieren. Bei dem Verfahren dieser Druckschrift wird die dielektrische Schicht anschließend nicht entfernt, sondern gegebenenfalls lediglich bis auf eine gewünschte Dicke rückgeätzt, bei der sie die Funktion einer Antireflexbeschichtung erfüllt. Als Ergebnis des Verfahrens wird eine Solarzelle mit überhängender dielektrischer Schicht erhalten, deren Basis über V-förmige Vertiefungen durch die Emitterschicht hindurch kontaktiert ist.

Es ist eine Aufgabe der vorliegenden Erfindung, ein Verfahren zur Herstellung von Kontaktstrukturen in Solarzellen bereitzustellen, das auf einfache und kostengünstige Weise realisiert werden kann.

Weiterhin soll das Verfahren die einfache Realisierung von Einseitenkontaktierungen von Dünnschicht- und Rückseitenkontakt-Solarzellen ermöglichen.

Die Aufgabe wird mit dem Verfahren nach Anspruch 1 gelöst. Vorteilhafte Ausgestaltungen sind Gegenstand der Unteransprüche.

Gemäß der vorliegenden Erfindung werden nach dem Positionieren der Ätzmaske über der ersten Schicht oder Schichtfolge die Vertiefungen durch die erste Schicht oder Schichtfolge bis an oder in die darunterliegende zweite Schicht geätzt. Erfindungsgemäß erfolgt das Ätzen hierbei so, daß die Ätzmaske unterätzt wird. Anschließend wird elektrisch leitfähiges Material in die Vertiefungen eingebracht, wobei die Ätzmaske aufgrund der Unterätzung und der daraus resultierenden überstehenden Ränder eine Schattenmaske für das Einbringen des Materials bildet. Das leitfähige Material wird nur in einem Maße bzw. bis zu einer Höhe in die Vertiefungen eingebracht, daß kein Kontakt zwischen dem leitfähigen Material und der ersten Schicht oder Schichtfolge entsteht. Abschließend wird die Ätzmaske entfernt. Das Positionieren der Ätzmaske erfolgt bei diesem Verfahren durch Auflegen oder Aufklemmen über der ersten Schicht oder Schichtfolge, so daß kein zusätzlicher Maskierungsschritt erforderlich ist.

Durch die besonders vorteilhaften Aspekte des erfindungsgemäßen Verfahrens nach Anspruch 1 läßt sich ohne zusätzliche Maskierung oder Isolation eine Kontaktierung der zweiten Schicht durch die erste Schicht hindurch realisieren. Dies ermöglicht die Kontaktierung einer Basisschicht durch die Emitterschicht einer Solarzelle hindurch.

Mit dem Verfahren lassen sich beliebige Muster, wie Gräben oder Löcher und Kombinationen von Gräben und Löchern, in einem Schritt realisieren.

Bei Anwendung des Verfahrens entsteht keine signifikante Schädigung der Solarzelle, und das zu behandelnde Material wird keinem mechanischen Streß ausgesetzt.

Das Einbringen des elektrisch leitfähigen Materials kann durch bekannte Verfahren, wie beispielsweise die in der Beschreibungseinleitung in Verbindung mit Figur 1 beschriebenen Verfahren, erfolgen.

Das erfindungsgemäße Verfahren stellt eine Verbesserung bekannter Kontaktstrukturen bzw. Kontaktierungsverfahren für Solarzellen dar. Die angegebenen Ätzvorgänge werden vorzugsweise durch ein Plasmaätzverfahren realisiert (vgl. Anspruch 4).

Durch die mit dem Verfahren erzielte (Selbst-) Maskierung werden beim Bedampfen Teile der Struktur nicht metallisiert, so daß bei der Metallisierung Kurzschlüsse zwischen Emitter und Basis verhindert werden. Es ist deshalb erstmals eine Kontaktstruktur möglich, bei der die Basis einer Solarzelle nach homogener Diffusion des Emitters von der Emitterseite aus kontaktiert werden kann.

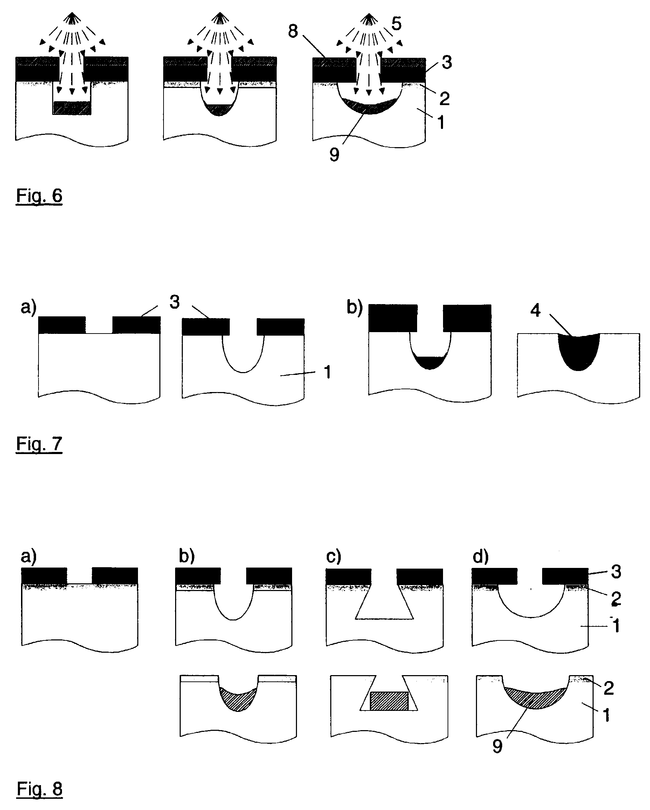

Der Selbstmaskierungseffekt kann durch Ätzverfahren erreicht werden, die die zur Erzeugung der Struktur notwendige Maske nicht angreifen, aber so unterätzen, daß die Maske die Flanken der Vertiefungen während der Metallisierung teilweise maskiert (vgl. Figur 6). Da für die Strukturerzeugung und für die Metallisierung dieselbe Maske verwendet wird, handelt es sich um sog. selbstjustierende Kontaktstrukturen.

Um die Abschattung der Solarzelle zu minimieren und gleichzeitig eine hohe Stromleitfähigkeit der Kontakte und einen geringen Kontaktwiderstand zu gewährleisten, sollten die Gräben oder Löcher schmal und tief sein, d.h. ein hohes Aspektverhältnis (Verhältnis von Tiefe zu Breite) aufweisen.

Die Erzeugung der erfindungsgemäßen Gräben- oder Löcherstrukturen kann nicht mittels Laser oder durch mechanische Formung erreicht werden. Die Strukturen sind beispielsweise durch naß-chemisches Ätzen in begrenztem Maße realisierbar.

Zum einen kann die Eigenschaft mancher Ätzlösungen ausgenutzt werden, in bestimmte Kristallrichtungen schneller zu ätzen als in andere. Auf entsprechend geschnittenem einkristallinem Material kann dies zu den gewünschten Strukturen führen. Allerdings ist deren Größe und Geometrie durch die Kristallstruktur des Materials vorgegeben.

Zum anderen können Ätzlösungen verwendet werden, die in alle Kristallrichtungen gleich schnell ätzen, und die Ätzmaske unterätzen, aber nicht angreifen. Allerdings erzeugt dieser rein isotrope Ätzabtrag lediglich halbkugelförmige Strukturen, d.h. ein schlechtes Aspektverhältnis.

Vorzugsweise werden daher Plasmaätzverfahren eingesetzt, mit denen sich in vorteilhafter Weise die Unterätzung kontrollieren läßt. Mit Plasmaätzverfahren läßt sich zudem ein hohes Aspektverhältnis erzielen.

Beim Plasmaätzen werden reaktive und/oder inerte Gase mittels Hochfrequenz- und/oder Mikrowellen-Einstrahlung zu Plasmen gezündet. Die dadurch entstehenden Radikale können mit der Probenoberfläche reagieren (isotropes chemisches Ätzen) und/oder entstehende Ionen werden darauf durch ein elektrisches Feld beschleunigt. Im Fall des Reaktive-Ionen-Ätzens (RIE, engl.: "Reactive Ion Etching") nutzt man dabei hauptsächlich reaktive Ionen, die nicht nur Oberflächenatome herausschlagen oder durch ihre Energie chemische Reaktionen unterstützen, sondern selbst mit Oberflächenatomen reagieren können. Der gerichtete Ionenstrom bewirkt einen anisotropen Abtrag. Durch geschickte Wahl der Prozeßparameter kann das Verhältnis von isotropem und anisotropem Ätzen und damit die Unterätzung der Strukturen gezielt beeinflußt werden. Dies ist unabhängig vom zu ätzenden Material und seiner Kristallorientierung und demnach auch für kostengünstiges multikristallines Material anwendbar.

Die bei allen Plasmaprozessen mögliche Schädigung des behandelten Materials ist für Solarzellen extrem kritisch. Im Gegensatz zu den meisten anderen Halbleiterbauelementen soll in Solarzellen die Verlustleistung so gering wie möglich gehalten werden. Das bedeutet, daß die Rekombination von Ladungsträgern weitestgehend unterdrückt werden muß, damit möglichst viele Ladungsträger die elektrischen Kontakte erreichen. Um dies zu gewährleisten, werden im vorliegenden Fall extrem schädigungsarme plasmaunterstützte Ätzverfahren eingesetzt, die keine negativen Einflüsse auf die Solarzelle haben. Erreicht wird dies durch geringe Ionenenergien und eine an den jeweiligen Prozeß angepaßte Kombination von Ätzgasen.

Die Tatsache, daß es sich bei Plasmaätzverfahren um trocken-chemische Verfahren handelt, erweitert den Anwendungsbereich über den naß-chemischer Verfahren hinaus. So ist beispielsweise bei Einsatz eines Plasmaätzverfahrens zur Erzeugung der erfindungsgemäßen Kontaktstrukturen in vorteilhafter Weise die Behandlung von Dünnschichtsolarzellen auf porösen Substratmaterialien möglich. Da Plasmaätzverfahren trockene Verfahren darstellen, kommt das zu behandelnde Material nicht in Berührung mit Flüssigkeiten. Auch können Schattenmasken als Ätzmaske verwendet werden, was sehr viel kostengünstiger ist als die für die Naßchemie nötigen photolithographischen Masken.

Die Erfindung wird nachfolgend anhand von Ausführungsbeispielen in Verbindung mit den Figuren näher erläutert. Hierbei zeigen
- Figur 1: Beispiele für Metallisierungsverfahren bei Solarzellen nach dem Stand der Technik;
- Figur 2: ein Schema einer einfachen Solarzelle nach dem Stand der Technik;
- Figur 3: Beispiele für eine maskenlose Metallisierung von Sägezahnstrukturen nach dem Stand der Technik;
- Figur 4: Beispiele für eine Einseitenkontaktierung einer Dünnschichtsolarzelle (a) und einer Rückseitenkontaktzelle (b) nach dem Stand der Technik;
- Figur 5: ein Beispiel für die Schritte zur Herstellung eines selektiven Emitters nach dem Stand der Technik;
- Figur 6: Beispiele für die selbstjustierende Metallisierung aufgrund von Selbstmaskierung durch Unterätzen der Ätzmaske gemäß einem Aspekt der Erfindung;
- Figur 7: ein Beispiel für die Schritte bei der selbstjustierenden Herstellung vergrabener Kontakte gemäß der Erfindung;
- Figur 8: ein Beispiel für die erfindungsgemäße Kontaktierung der Basis einer Solarzelle durch eine homogene Emitterschicht hindurch;
- Figur 9: ein Beispiel für das Ergebnis der Metallisierung einer Struktur ohne Einsatz des erfindungsgemäßen Verfahrens.

Die in den Figuren 1 bis 5 dargestellten Beispiele für Verfahren zur Metallisierung, Kontaktierung und Ausgestaltung von Solarzellen im Stand der Technik wurden bereits in der Beschreibungseinleitung erläutert.

In Figur 6 sind Beispiele für die Selbstmaskierung durch Unterätzen der Ätzmaske (3) gemäß einem Aspekt der Erfindung dargestellt. In der Figur sind hierbei die Basisschicht (1) einer Solarzelle mit der darauf befindlichen Emitterschicht (2) und der Ätzmaske (3), der nach dem Abscheiden des Metalls auf der Oberfläche der Emitterschicht gebildete Emitterkontakt (8) und der in den Vertiefungen entstandene Basiskontakt (9) zu erkennen. Beim Unterätzen wird die Ätzmaske (3) selbst nicht angegriffen. Die genaue Form der Vertiefungen spielt hierbei keine Rolle.

In der rechten Abbildung ist eine REM-Aufnahme einer mit dem Verfahren realisierten Struktur dargestellt. Die Erzeugung dieser Struktur kann beispielsweise in einem ECR-Reaktor im Downstream-Modus durchgeführt werden. Bei Einsatz eines Ätzgases wie Schwefelhexafluorid SF₆ bei einem Gasfluß von 30 sccm, einem Druck von 3 Pa, einer Mikrowellenleistung von 400W, einer Probentemperatur von 10°C, einem Abstand Probe-Plasma von 200 mm und einer Ätzzeit von 15 min kann beispielsweise eine Grabentiefe von 15 µm erreicht werden. Bei Einsatz zusätzlicher Hochfrequenz- (RIE-) Leistung von 20 W können die Gräben in der gleichen Zeit schmäler und tiefer realisiert werden.

Ein Anwendungsbeispiel (Beispiel 1) des erfindungsgemäßen Verfahrens stellt die selbstjustierende Metallisierung von vergrabenen Kontakten in einer Solarzelle dar. Das Verfahren stellt eine Verbesserung der mittels Laser oder durch Sägen erzeugten Gräben bezüglich Aspektverhältnis und Schädigung einer "buried contact cell" dar.

Erfolgt die Strukturierung der Oberfläche vor der Emitterbildung, kann ein Emitterkontakt realisiert werden. Erfolgt die Strukturierung auf dem Basisgebiet der Solarzelle, wird ein Basiskontakt realisiert.

Zur Erzeugung der Gräben (oder Löcher) wird eine Maske (3) verwendet. Durch Plasmaätzen (z.B. RIE oder mikrowellenunterstützte RIE-Verfahren wie ECR-RIE) kann eine sehr schmale, tiefe Struktur erzeugt werden, ohne die Maske zu beschädigen, wie dies in Figur 7a dargestellt ist. In Figur 7a ist hierbei eine Unterätzung der Maske (3) zu erkennen. Die Maske wird entsprechend auch zur Metallisierung verwendet und erst danach entfernt. Nach dem Entfernen der Maske erhält man einen metallisierten Graben (4)(Figur 7b). Eine Justage der Metallisierungsmaske auf die Struktur wird dadurch hinfällig. Die Metallisierung kann entweder durch Bedampfen erfolgen, oder durch Füllen der Strukturen mit Metallpaste. Dies kann durch Rakeln oder ganzflächiges Drucken geschehen.

Ein weiteres erfindungsgemäßes Ausführungsbeispiel (Beispiel 2) erlaubt erstmals die Kontaktierung der Basis einer Solarzelle durch einen homogenen Emitter, d.h. eine die ganze Oberfläche bedeckende Emitterschicht hindurch. Dies ist in Figur 8 dargestellt. Dies entspricht einer selbstjustierenden Kontaktierung der Basis bei Einseitenkontaktierung. Dabei ist eine einzige Maske für die Erzeugung der erfindungsgemäßen Gräben oder Löcher und die anschließende Metallisierung ausreichend. Sowohl die aufwendige Herstellung eines selektiven Emitters als auch die Justage der Metallisierungsmaske auf die Struktur entfallen. Damit steht eine einfache Solarzellenkontaktierung von einer Seite zur Verfügung, die sowohl für Dünnschichtzellen auf isolierendem Substrat als auch für Rückseitenkontaktzellen verwendet werden kann.

Die Gräben oder Löcher werden wie im vorangegangenen Beispiel (Beispiel 1) durch Verwendung einer Maske (3) auf der Emitterschicht (2) erzeugt (Figur 8a). Die Emitterschicht (2) befindet sich auf der Basisschicht (1). Bei dem Verfahren wird entweder die Maske (3) soweit unterätzt (Figuren 8b und 8d) oder die Flankenform der Vertiefungen so geätzt (Figur 8c), daß eine Maskierung des Emitters (2) bei der Metallisierung gewährleistet ist. Die Metallisierung erfolgt durch Bedampfen und eventuell anschließende galvanische Verdickung des Metalls. Da die Bedampfung nicht genau senkrecht stattfindet, muß auch der Emitterbereich in der Struktur bzw. den Vertiefungen maskiert sein, vergleichbar einem Schattenwurf. Dies wird durch die erfindungsgemäße Struktur sichergestellt. Die Abscheidung oder Aufbringung des Metalls darf für die Realisierung des Basiskontaktes (9) nur bis zu einer Höhe innerhalb der Vertiefungen erfolgen, bei der die Metallisierung (9) noch keinen Kontakt zur Emitterschicht (2) hat. Dies ist in den unteren Abbildungen der Figuren 8b bis 8d zu erkennen. Die dargestellte Querschnittsform der Metallisierung (9) ergibt sich aufgrund der Maskierung.

Die Gräben oder Löcher können bei dieser Anwendung prinzipiell auch naß-chemisch erzeugt werden. Da die Ätzrate dann allerdings isotrop, d.h. horizontal wie vertikal gleich ist, sind nur recht breite Strukturen realisierbar, die eine entsprechend große Abschattung der Solarzelle oder einen hohen Kontaktwiderstand und geringe Stromleitfähigkeit der Kontakte mit sich bringen. Figur 8d zeigt hierbei eine Form der Vertiefung bzw. des Grabens, wie sie durch naß-chemisches Ätzen erzeugt werden kann.

Geeignete Ätzlösungen oder Materialien bzw. Kristallrichtungen oder auch die geeignete Wahl der Parameter beim Plasmaätzverfahren zur Erzeugung der erfindungsgemäßen Strukturen können jederzeit der Fachliteratur entnommen werden.

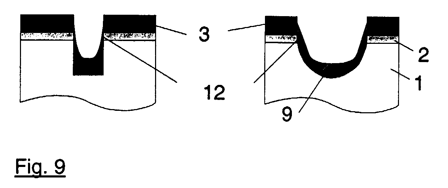

Wird für die Kontaktierung keine erfindungsgemäße Struktur mit Selbstmaskierungseffekt verwendet, und erfolgt die Kontaktierung nicht nach dem erfindungsgemäßen Verfahren der Unterätzung einer Maske (3) mit anschließender Metallisierung durch dieselbe Maske, so kommt es zu Kurzschlüssen (12) zwischen Emitter (2) und Basiskontakt (9), wie in Figur 9 dargestellt. Die Solarzelle ist damit unbrauchbar.

## Patentansprüche

1. Verfahren zur Herstellung von Kontaktstrukturen in Solarzellen, die zumindest eine erste Schicht oder Schichtfolge (2) über einer zweiten Schicht (1) aufweisen, mit folgenden Schritten:
- Positionieren einer Ätzmaske (3) über der ersten Schicht oder Schichtfolge (2), wobei die Ätzmaske die Position der Kontaktstrukturen festlegt;
- Ätzen von Vertiefungen an den durch die Ätzmaske (3) vorgegebenen Stellen durch die erste Schicht oder Schichtfolge (2) bis an oder in die darunterliegende zweite Schicht (1) derart, daß die Ätzmaske (3) unterätzt wird; und
- Einbringen von elektrisch leitfähigem Material (9) in die Vertiefungen, wobei die Ätzmaske (3) eine Schattenmaske für das Einbringen des Materials bildet, und das leitfähige Material nur so eingebracht wird, daß kein Kontakt zwischen dem leitfähigen Material (9) und der ersten Schicht oder Schichtfolge (2) entsteht;
dadurch gekennzeichnet,
daß das Positionieren der Ätzmaske (3) durch Auflegen oder Aufklemmen über der ersten Schicht oder Schichtfolge (2) erfolgt, wobei die Ätzmaske (3) nach dem Einbringen des elektrisch leitfähigen Materials (9) in die Vertiefungen wieder entfernt wird.

2. Verfahren nach Anspruch 1,
dadurch gekennzeichnet,
daß das Unterätzen der Ätzmaske (3) durch gezielte Steuerung von Parametern des Ätzverfahrens und/oder durch unterschiedliches Ätzverhalten der für Ätzmaske und/oder erste Schicht oder Schichtfolge eingesetzten Materialien realisiert wird.

3. Verfahren nach Anspruche 1 oder 2,
dadurch gekennzeichnet,
daß die erste Schicht (2) eine Emitterschicht und die zweite Schicht (1) eine Basisschicht der Solarzelle ist.

4. Verfahren nach einem der Ansprüche 1 bis 3,
dadurch gekennzeichnet,
daß zum Ätzen ein Plasmaätzverfahren eingesetzt wird.
